# EUROPEAN PATENT APPLICATION

(11) **EP 4 632 744 A1**
(43) Date of publication of application: **15.10.2025**
(21) Application number: 23900531.7
(22) Date of filing: 28.11.2023
(51) Int. Cl.: G11B 33/02, G11B 33/14, H05K 9/00, G06F 1/18, H05K 1/02, H05K 1/14, H05K 3/36

(54) **CONNECTION STRUCTURE, OPTICAL DISK DRIVE**

(30) Priority: 06.12.2022 JP 2022195205
(71) Applicant: Sony Interactive Entertainment Inc., Tokyo 108-0075 (JP)
(72) Inventor: HIROSE, Kenji, Tokyo 108-0075 (JP); NOZAWA, Tetsufumi, Tokyo 108-0075 (JP); CHIBA, Tsuneya, Tokyo 108-0075 (JP); NAKAGAWA, Kazuto, Tokyo 108-0075 (JP)
(74) Representative: D Young & Co LLP
(86) International application number: PCT/JP2023/042615
(87) International publication number: WO 2024/122415

(57) **Abstract**

There are provided a connection structure and an optical disk drive (20) capable of suppressing the effects of noise. The connection structure allows electronic equipment (10) and the optical disk drive (20) detachably attachable thereto to be electrically connected with each other. The connection structure includes a connector terminal (22) provided on the optical disk drive (20), a connector terminal (13) provided on the electronic equipment (10) in a manner connectable to the connector terminal (22), a circuit board (11) housed in a housing (12) of the electronic equipment (10), the circuit board (11) having the connector terminal (13) mounted thereon, a ground part provided on the circuit board (11), and a gasket (40) allowing the ground part and a metal part of the optical disk drive (20) to be electrically connected with each other in a state where the connector terminal (22) and the connector terminal (13) are connected with each other.

## Description

### [Technical Field]

The present invention relates to a connection structure and an optical disk drive.

### [Background Art]

PTL 1 and PTL 2 each disclose an optical disk drive mounted on electronic equipment such as a game machine, a personal computer, or an AV (audio visual) device.

### [Citation List]

### [Patent Literature]

[PTL 1]
   JP 2015-022780A
[PTL 2]
   JP 2015-022779A

### [Summary]

### [Technical Problem]

Electronic equipment with no optical disk drive mounted thereon may be connected with an external optical disk drive via a cable. However, it can be cumbersome for users to attach an external optical disk drive to the electronic equipment, and the exposed cable outside the electronic equipment can be annoying. An alternative to this may be to adopt a structure for attaching the optical disk drive to the electronic equipment without recourse to cables. This structure, however, requires taking countermeasures against noise such as electromagnetic waves generated near the connectors involved.

It is therefore an object of the present disclosure to provide a connection structure and an optical disk drive capable of suppressing effects of noise.

### [Solution to Problem]

According to the present disclosure, there is provided a connection structure allowing electronic equipment and an optical disk drive detachably attachable thereto to be electrically connected with each other. The connection structure includes a first connector terminal provided on the optical disk drive, a second connector terminal provided on the electronic equipment in a manner connectable to the first connector terminal, a circuit board housed in a housing of the electronic equipment, the circuit board having the second connector terminal mounted thereon, a ground part provided on the circuit board, and a conductive member causing the ground part and a metal part of the optical disk drive to be electrically connected with each other in a state where the first connector terminal and the second connector terminal are connected with each other.

According to the present disclosure, there is also provided an optical disk drive detachably attachable to electronic equipment. The optical disk drive includes a connector terminal connectable to an equipment-side connector terminal mounted on a circuit board of the electronic equipment, and a conductive member electrically connected to a ground part provided on the circuit board in a state where the connector terminal is connected to the equipment-side connector terminal.

### [Brief Description of Drawings]

[FIG. 1A]

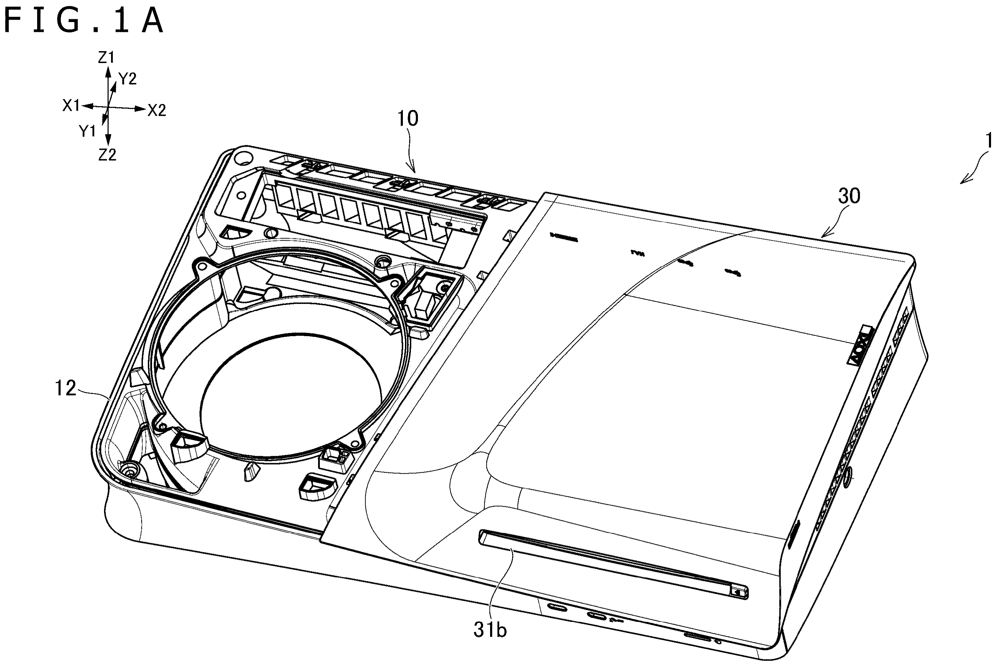

   FIG. 1A is a perspective view depicting an electronic equipment unit according to an embodiment.
[FIG. 1B]

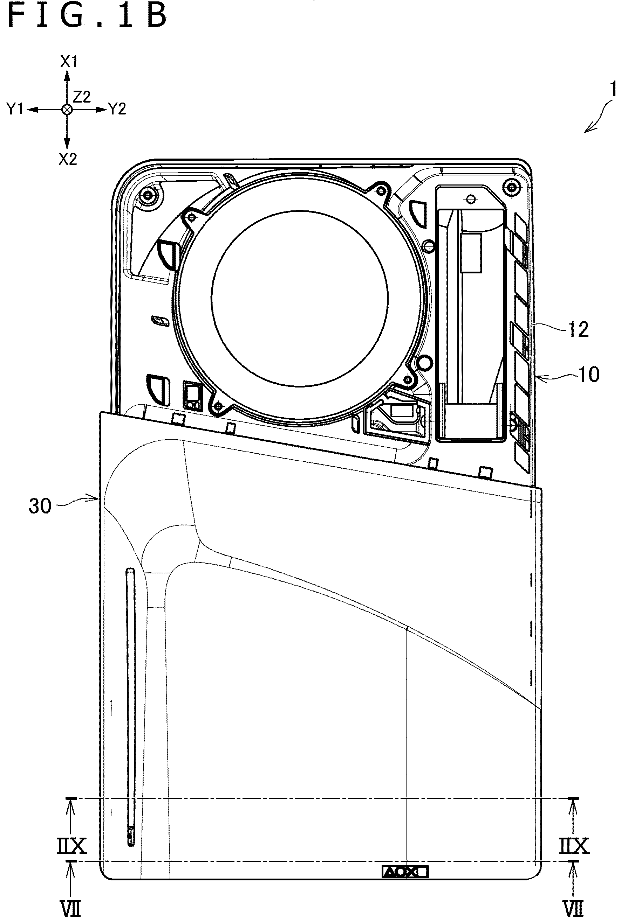

   FIG. 1B is a plan view depicting the electronic equipment unit according to the embodiment as viewed from above.
[FIG. 2]

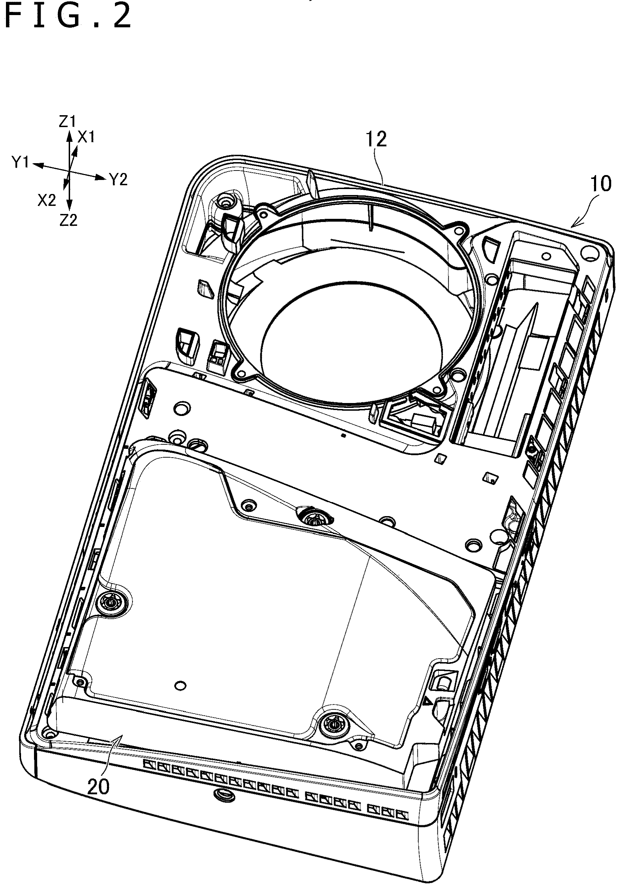

   FIG. 2 is a perspective view depicting the electronic equipment unit according to the embodiment from which a drive cover covering an optical disk drive has been removed.
[FIG. 3]

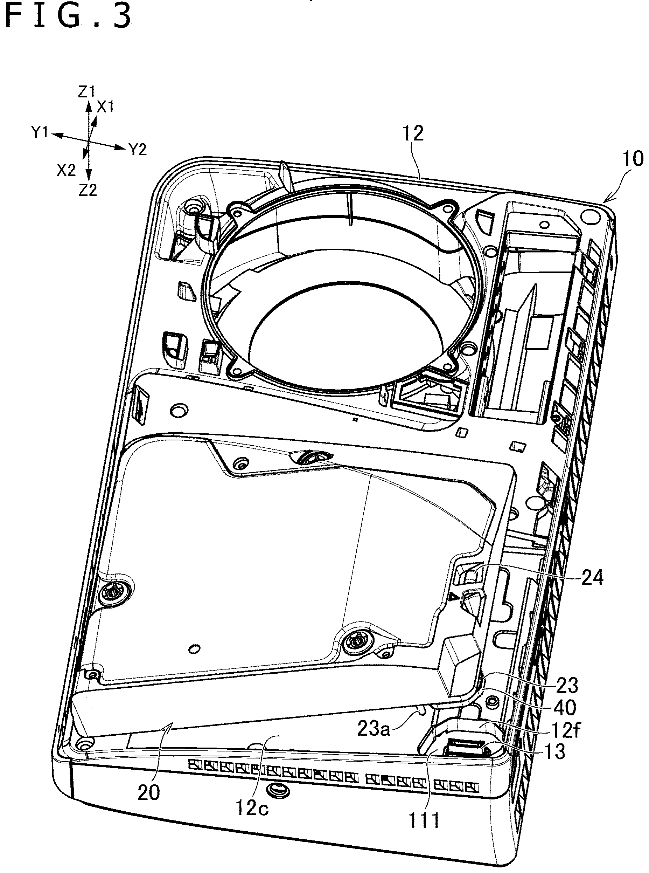

   FIG. 3 is a perspective view depicting how the optical disk drive is about to be attached to electronic equipment in the electronic equipment unit according to the embodiment.
[FIG. 4]

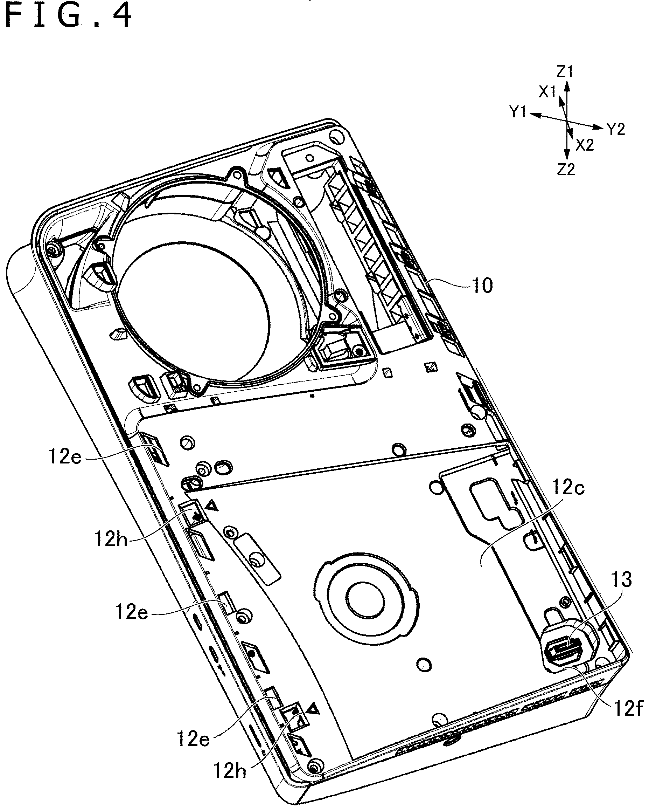

   FIG. 4 is a perspective view depicting the electronic equipment according to the embodiment.
[FIG. 5]

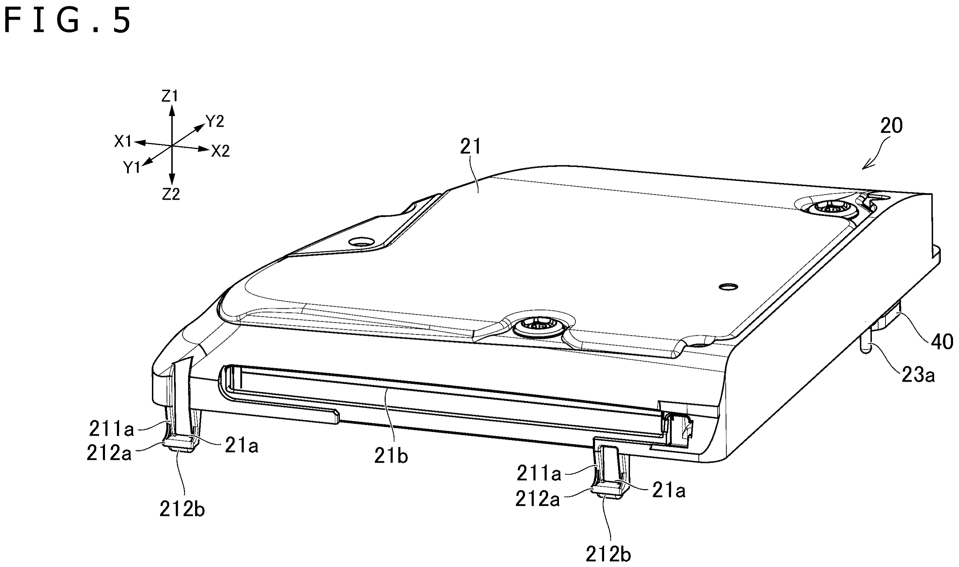

   FIG. 5 is a perspective view depicting the optical disk drive according to the embodiment as viewed obliquely from above.
[FIG. 6]
   FIG. 6 is a perspective view depicting the optical disk drive according to the embodiment as viewed obliquely from below.
[FIG, 7]
   FIG. 7 is a cross-sectional view taken along section line VII-VII in FIG. 1B.
[FIG. 8A]

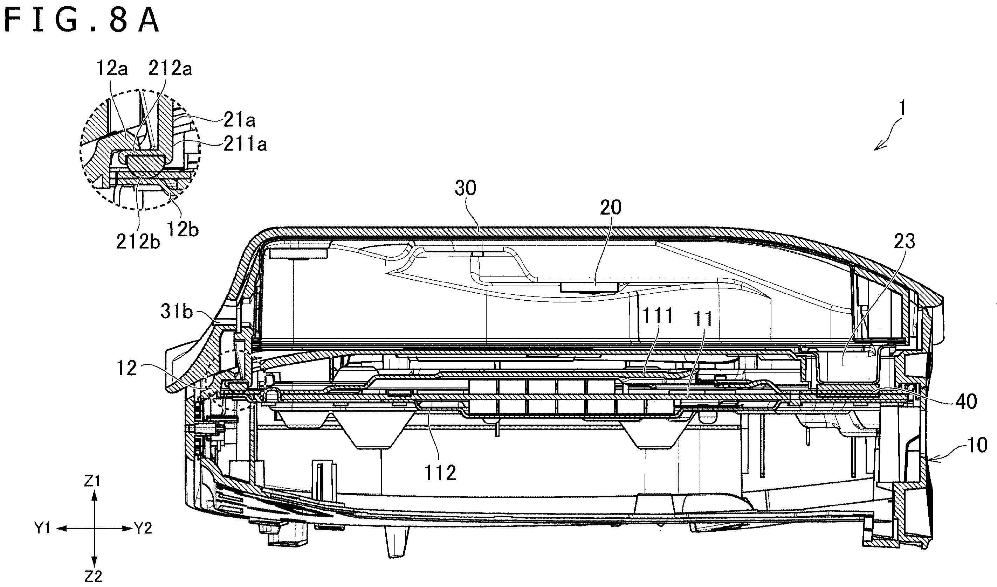

   FIG. 8A is a cross-sectional view taken along section line IIX-IIX in FIG. 1B.
[FIG. 8B]

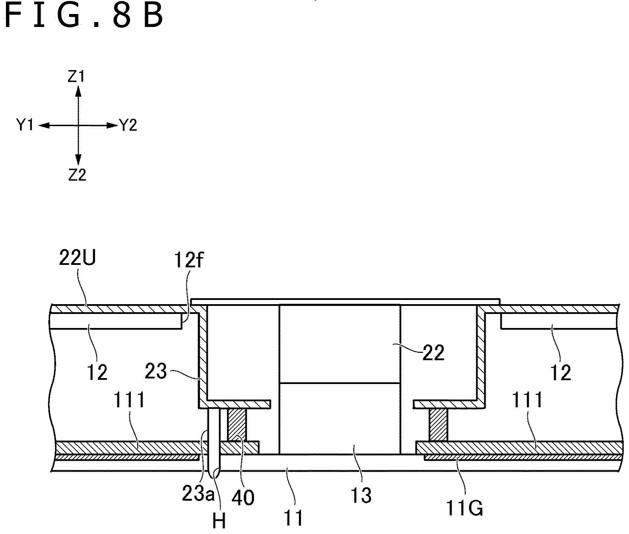

   FIG. 8B is a schematic cross-sectional view schematically depicting a connector connection structure of the electronic equipment unit according to the embodiment.
[FIG. 9]

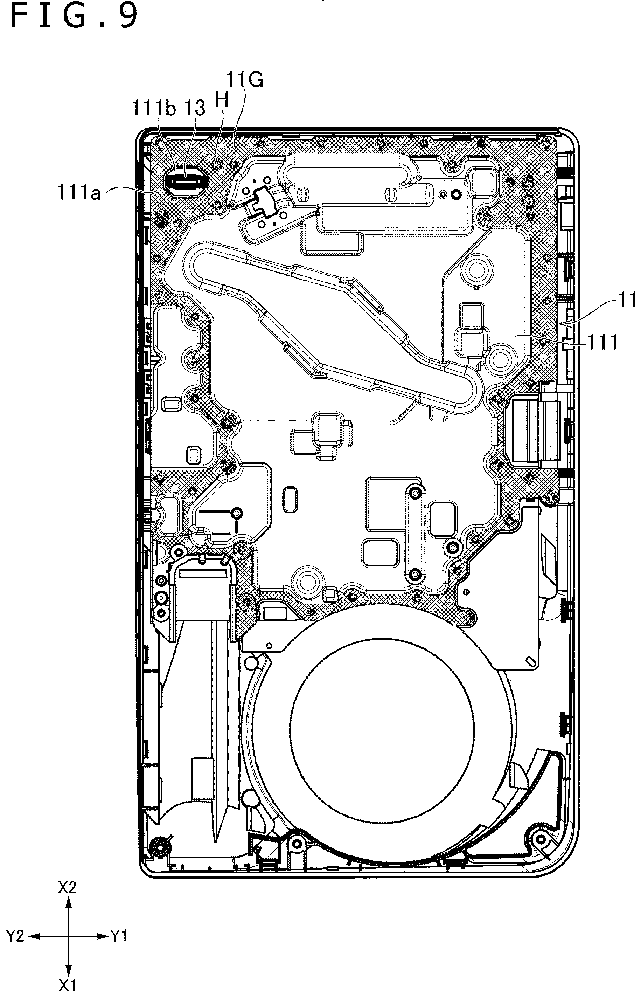

   FIG. 9 is a top view depicting a circuit board housed in a housing of the electronic equipment as viewed from above.
[FIG. 10]

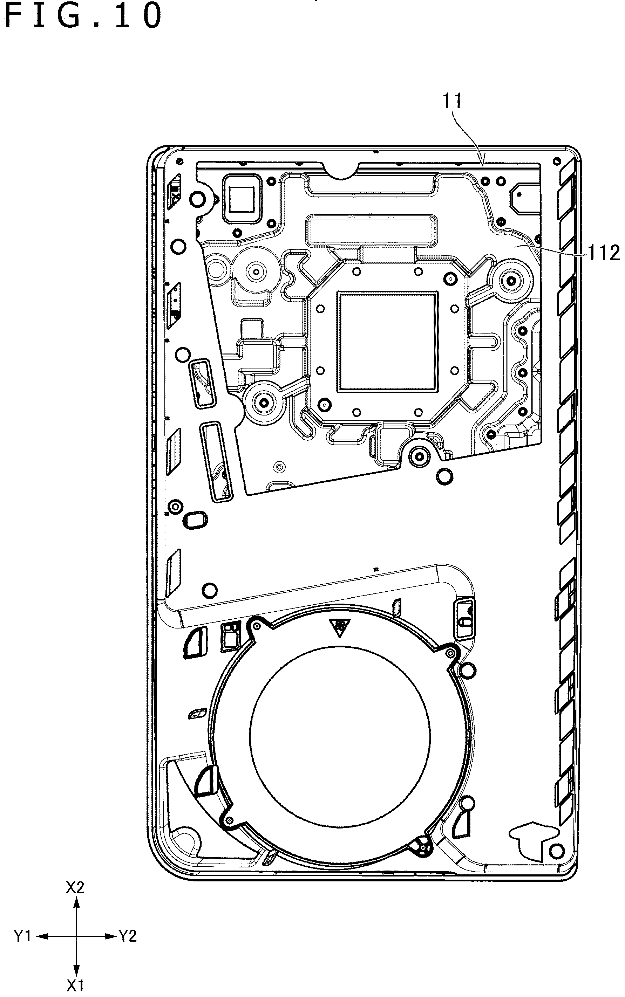

   FIG. 10 is a bottom view depicting the circuit board housed in the housing of the electronic equipment as viewed from below.
[FIG. 11]

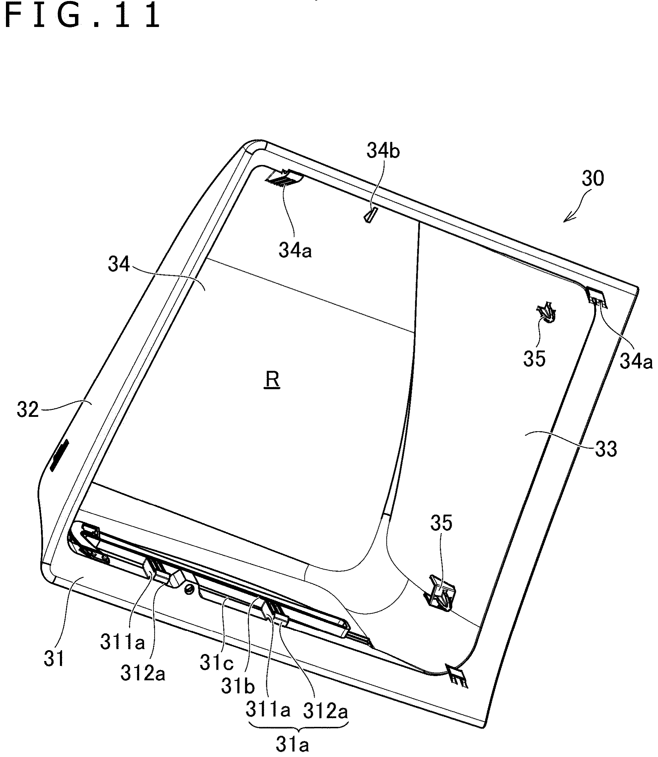

   FIG. 11 is a perspective view depicting the drive cover as viewed obliquely from below.
[FIG. 12]

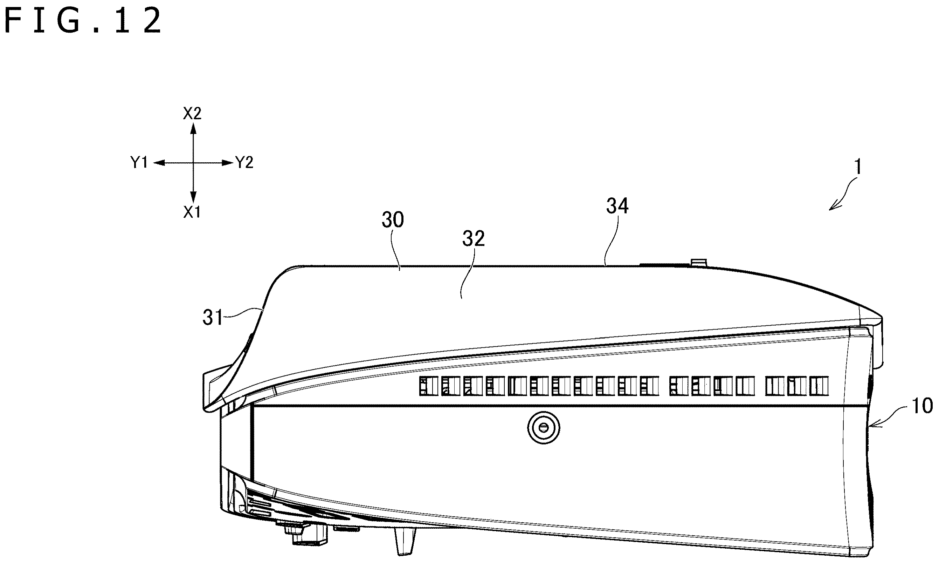

   FIG. 12 is a left view depicting how the optical disk drive is covered by the drive cover as viewed from left.
[FIG. 13]

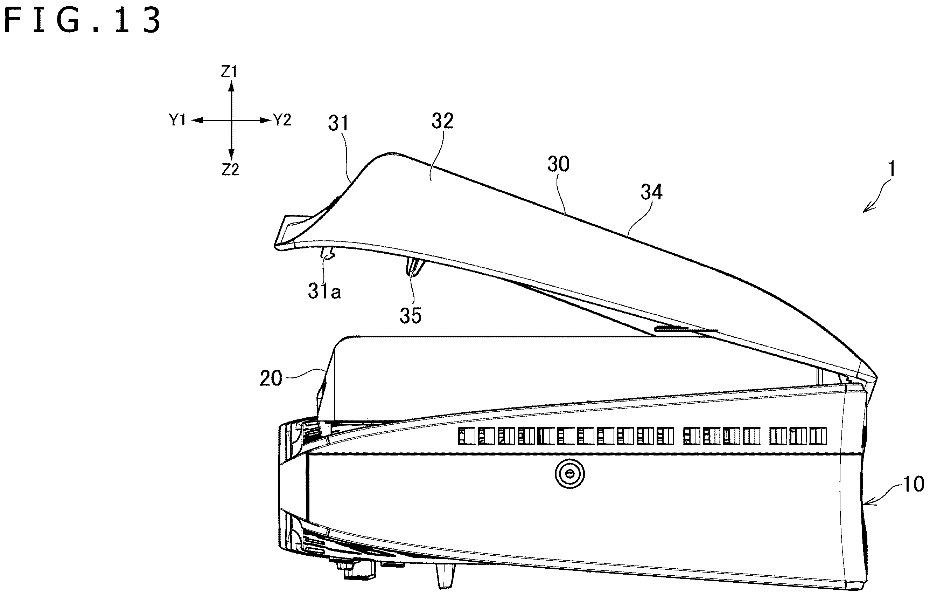

   FIG. 13 is a left view depicting how the optical disk drive is about to be covered by the drive cover as viewed from left.
[FIG. 14]

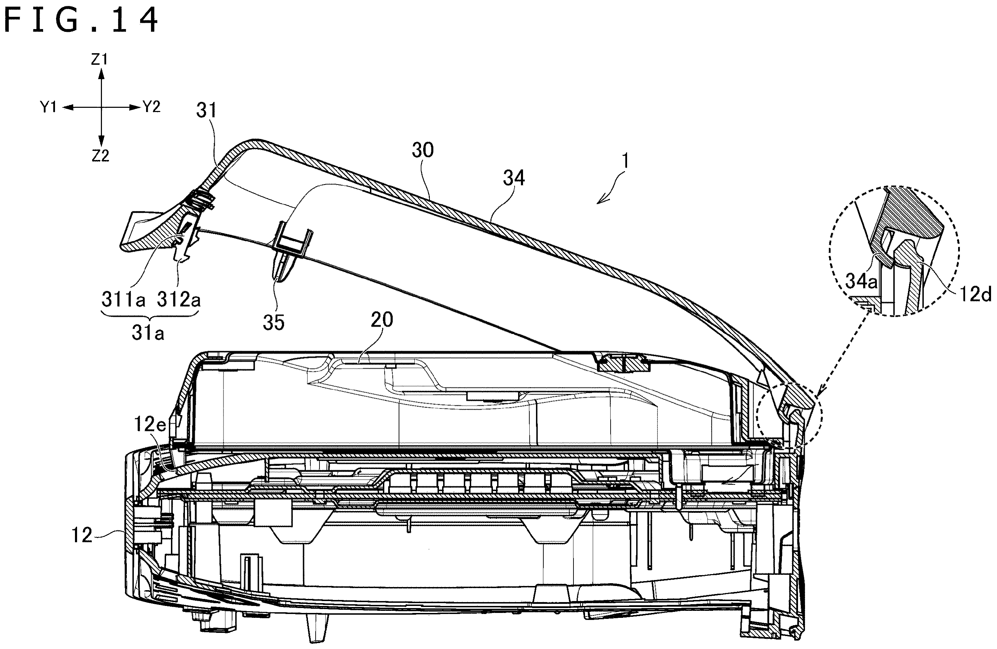

   FIG. 14 is a cross-sectional view taken along a section line passing through back locking pawls.

### [Description of Embodiment]

An electronic equipment unit 1 of an embodiment of the present invention (referred to as the embodiment hereunder) is described below. The electronic equipment unit 1 includes electronic equipment 10 and an optical disk drive 20 removably attachable to the electronic equipment 10. The optical disk drive 20 is configured to be attachable to and detachable from the electronic equipment 10 manually by a user without recourse to tools. The optical disk drive 20 is configured to be directly connectable to the electronic equipment 10 without cables exposed outside the electronic equipment 10.

In the description that follows and in the accompanying drawings, the directions indicated by reference signs Y1 and Y2 will be referred to as front and back, respectively, the directions indicated by reference sigs Z1 and Z2 will be referred to as above and below, respectively, and the directions indicated by reference signs X1 and X2 will be referred to as right and left, respectively. These directions are used to explain the relative positions of the components, parts, and members of the electronic equipment 10 and are not limitative of the posture of the electronic equipment 10. For example, the electronic equipment 10 may be used in a state where its upper part in the drawings (i.e., portion on the side indicated by Z1) is positioned downside. Note that the drawings depict examples in which the optical disk drive 20 is attached to the electronic equipment 10 in such a manner that an optical disk is to be inserted front to back. In the embodiment, the front-back direction is a first width direction of the optical disk drive 20, and the right-left direction is a second width direction of the optical disk drive 20.

FIG. 1A is a perspective view depicting the electronic equipment unit of the embodiment. FIG. 1B is a plan view depicting the electronic equipment unit of the embodiment as viewed from above. FIG. 2 is a perspective view depicting the electronic equipment unit according to the embodiment from which a drive cover covering an optical disk drive has been removed. FIG. 3 is a perspective view depicting how the optical disk drive is about to be attached to electronic equipment in the electronic equipment unit according to the embodiment. FIG. 4 is a perspective view depicting the electronic equipment of the embodiment. FIGS. 1 through 4 depict the electronic equipment 10 with some portions of its exterior omitted.

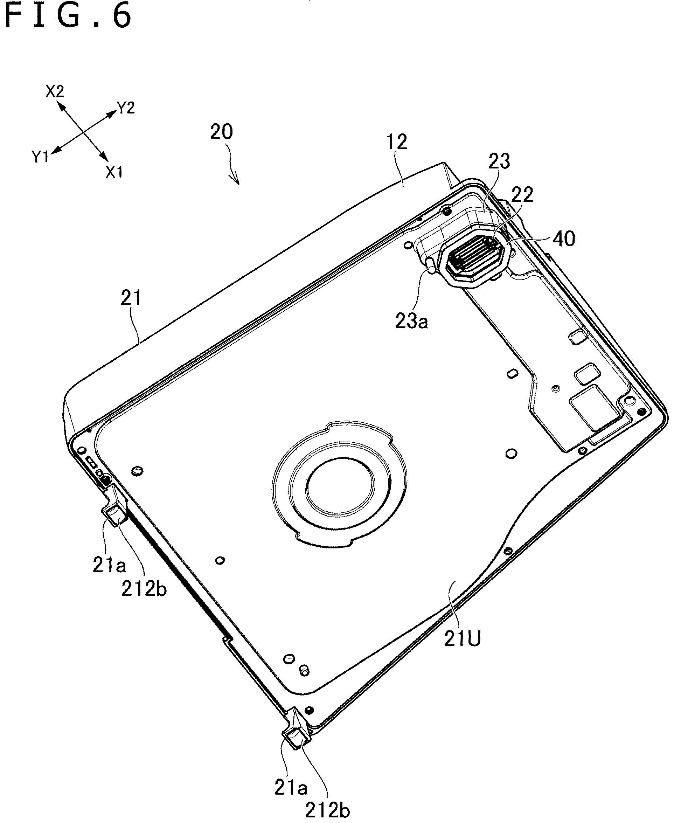

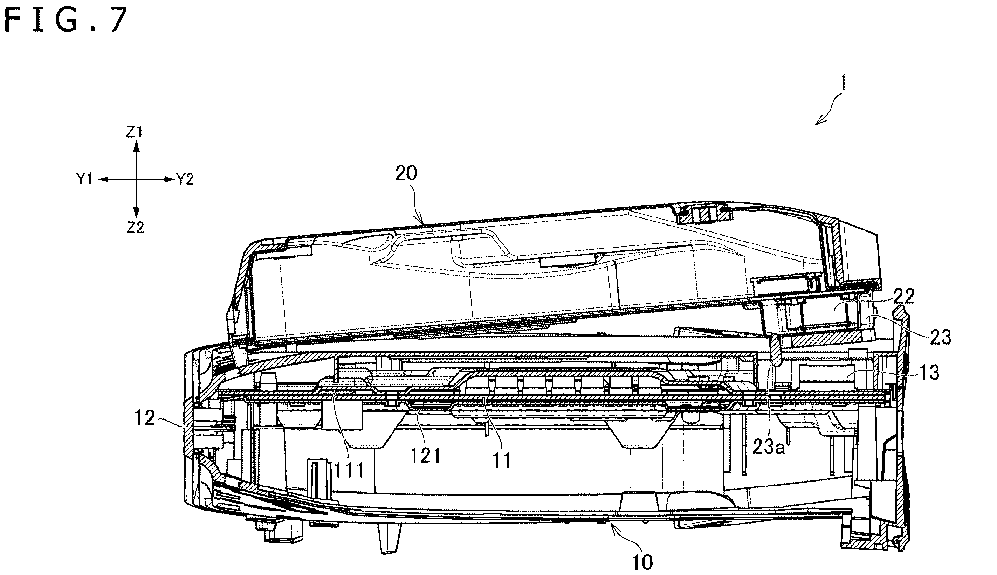

FIG. 5 is a perspective view depicting the optical disk drive of the embodiment as viewed obliquely from above. FIG. 6 is a perspective view depicting the optical disk drive of the embodiment as viewed obliquely from below. FIG. 7 is a cross-sectional view taken along section line VII-VII in FIG. 1B. Specifically, FIG. 7 is a cross-sectional view taken along a section line passing through a guide pin, indicating the optical disk drive about to be attached to the electronic equipment. FIG. 8A is a cross-sectional view taken along section line IIX-IIX in FIG. 1B. Specifically, FIG. 8A is a cross-sectional view taken of the electronic equipment unit along a section line passing through locking pawls provided on a case of the optical disk drive. FIG. 8A also includes an enlarged sectional view depicting a locking pawl and its surrounding members provided on the case of the optical disk drive. FIG. 8B is a schematic cross-sectional view schematically depicting a connector connection structure of the electronic equipment unit of the embodiment.

### [Overview of the electronic equipment 10]

The electronic equipment 10 is an entertainment apparatus that functions as a game machine or an AV device, for example. However, this is not limitative of the electronic equipment, which may also be a personal computer, for example. The electronic equipment 10 outputs moving image data generated by execution of game programs and audio/video data acquired via networks to a display apparatus such as a television receiver. The electronic equipment 10 also outputs to the display apparatus the audio/video data acquired from an optical disk, which is a recording medium inserted into the optical disk drive 20.

The electronic equipment 10 has a housing 12 that houses a circuit board 11 (see FIGS. 7, 9, 10, etc.). Electronic components such as a CPU (central processing unit) and a GPU (graphics processor unit) may be mounted on the circuit board 11. Although not depicted, the housing 12 may preferably house a cooling fan, heat pipes, heat sinks, or other parts for cooling the electronic components mounted on the circuit board 11.

### [Overview of the optical disk drive 20]

The optical disk drive 20 is an apparatus that uses laser light or similar means to read information stored on optical disks. The optical disks are information recording media such as CDs (compact discs), DVDs (digital versatile discs), and Blu-Ray Discs (registered trademark). The optical disk drive 20 may preferably be compatible with the optical disks 12 cm in diameter, for example.

The optical disk drive 20 has a case 21 on which is formed an insertion opening 21b through which an optical disk is to be inserted, as depicted in FIG. 5 and elsewhere. The optical disk drive 20 is configured to have the case 21 housing a transport mechanism that transports the optical disk, a catching mechanism that secures the optical disk, or the like. The case 21 has a box-like shape making up at least part of the exterior of the optical disk drive 20. The case 21 may preferably constitute the exterior of the optical disk drive 20 in conjunction with a metal lower plate 21U depicted in FIG. 6. The lower plate 21U may be secured to the case 21 either directly or indirectly via some other member. The case 21 is not limited to being made up of a single member and may be constituted by a combination of multiple members.

### [Detachable structure]

The optical disk drive 20 has a connector terminal 22 (first connector terminal) exposed from its left back portion to the outside, as depicted in FIG. 6 and elsewhere. The connector terminal 22 is mounted on the circuit board housed in the case 21. The electronic equipment 10 has a connector terminal 13 (equipment-side connector, second connector terminal) exposed from its left back portion to the outside, as depicted in FIG. 4 and elsewhere. The connector terminal 13 is mounted on the circuit board 11 housed in the housing 12. The housing 12 has an opening 12f that exposes the connector terminal 13 to the outside.

The connector terminal 22 is provided in a manner protruding downward beyond the lower plate 21U that makes up at least part of the exterior of the optical disk drive 20 and constitutes a bottom face of the optical disk drive 20.

In a state where a supported part formed on the case 21 is supported by the electronic equipment 10, the connector terminal 22 is provided pivotably between a non-connecting position where the connector terminal 22 is not connected with the connector terminal 13 on one hand, and a connecting position where the connector terminal 22 is connected with the connector terminal 13 on the other hand.

The optical disk drive 20 includes locking pawls 21a, which are supported parts formed on the case 21 as depicted in FIG. 5. The locking pawls 21a are formed on a front end of the case 21. There are two locking pawls 21a formed apart from each other in the right-left direction (second width direction). Specifically, the two locking pawls 21a are formed on a front end of a right portion of the case 21 and on a front end of a left portion thereof.

The locking pawl 21a each include an extension part 211a that extends downward and a claw part 212a that protrudes forward from a bottom end of the extension part 211a. The claw part 212a may preferably have its tip in the protruding direction positioned in front of the front end of the case 21.

Further, an elastic part 212b is provided under each of the claw parts 212a. As depicted in the enlarged sectional view in FIG. 8A, the elastic part 212b is provided in a manner protruding downward from a bottom end of the claw part 212a.

As depicted in FIG. 4, the electronic equipment 10 has locking holes 12h formed in the housing 12. The locking holes 12h are formed at the front of the housing 12. Further, there are two locking holes 12h formed apart from each other in the right-left direction in the housing 12. Specifically, the locking holes 12h are formed at the front of the housing 12 in a manner corresponding to the positions of the locking pawls 21a of the optical disk drive 20.

Further, as depicted in the enlarged sectional view in FIG. 8A, the electronic equipment 10 has an upper contact part 12a that is in contact with a top face of the claw part 212a of the locking pawl 21a, and a lower contact part 12b that is in contact with a bottom face of the elastic part 212b provided on the claw part 212a, in a state where the locking pawls 21a are inserted in the locking holes 12h. In the embodiment, the upper contact part 12a is part of the housing 12, and the lower contact part 12b is part of an upper shield 111, to be discussed later.

When the optical disk drive 20 is to be attached to the electronic equipment 10, the two locking pawls 21a are first inserted into the two locking holes 12h in a forward-downward direction. That is, as depicted in FIG. 3, in a state where the front of the optical disk drive 20 is tilted downward, the locking pawls 21a are inserted into the locking holes 12h. The locking pawls 21a inserted in the locking holes 12h are locked by the upper contact parts 12a.

In a state where the locking pawls 21a are locked by the upper contact parts 12a, the optical disk drive 20 is pivoted on the locking pawls 21a acting as a fulcrum with respect to the electronic equipment 10. The back of the optical disk drive 20 is thus moved downward. As the back of the optical disk drive 20 is being moved downward, the elastic part 212b is sandwiched between the claw parts 212a and the lower contact parts 12b and compressed thereby. As the back of the optical disk drive 20 is further moved downward, the optical disk drive 20 is placed onto a placement surface 12c of the housing 12 of the electronic equipment 10.

Further, as depicted in FIG. 6, the optical disk drive 20 also has a guide pin 23a protruding downward. The guide pin 23a is provided in order to guide the connector terminal 22 being moved when the connector terminal 22 is connected to the connector terminal 13. For this reason, the guide pin 23a may preferably be located in the left back portion of the optical disk drive 20 and near the connector terminal 22.

Specifically, the guide pin 23a may preferably be provided on a connector housing 23 that houses at least part of the connector terminal 22. The connector housing 23 is made of metal and protrudes downward from the lower plate 21U, as depicted in FIG. 6. In a state where the connector terminal 22 is in the connecting position, at least part of the connector housing 23 fits in the opening 12f formed on the housing 12 of the electronic equipment 10 and is thereby housed inside the housing 12.

Further, a guide hole H through which the guide pin 23a is inserted is formed on the electronic equipment 10, as depicted in FIG. 8B. The guide hole H may preferably be formed on at least a portion of multiple members housed in the housing 12 of the electronic equipment 10. FIGS. 8B and 9 depict an example in which the guide hole H is formed on the circuit board 11 and on the upper shield 111.

The guide hole H may preferably be formed to let the guide pin 23a be inserted therethrough before the connector terminal 22 is connected to the connector terminal 13. For this reason, the tip of the guide pin 23a in its extending direction may preferably be positioned further from the lower plate 21U to be placed on the electronic equipment 10 than the tip of the connector terminal 22 protruding from the lower plate 21U is. An inner circumference surface of the guide hole H may preferably have a function of guiding the guide pin 23a being moved. In the embodiment, the guide pin 23a has a cylindrical shape, and the guide hole H has a circular opening as viewed from above. Note that the guide hole H may be either a through-hole or a bottomed groove.

The guide pin 23a may preferably be disposed in front of the connector terminal 22. That is, the guide pin 23a may preferably be located closer to the locking pawls 21a than the connector terminal 22 is, in the front-back direction. Also, the guide pin 23a may preferably be located more to the left than the connector terminal 22.

When the locking pawls 21a of the optical disk drive 20 are to be locked by the electronic equipment 10, the optical disk drive 20 is pushed forward. At this point, if the locking pawls 21a are not inserted precisely into the locking holes 12h, the position of the connector terminal 22 relative to the connector terminal 13 is shifted forward. In a case where the guide pin 23a is at the back of or at the same position of the connector terminal 22 in the front-back direction, the guide pin 23a can interfere inadvertently with the connector terminal 13 upon connection of the connector terminal 22 to the connector terminal 13. In the embodiment, the guide pin 23a is disposed in front of the connector terminal 22, so that the guide pin 23a does not interfere with the connector terminal 13 even if the position of the connector terminal 22 relative to the connector terminal 13 is shifted forward.

In the above-described detachable structure of the embodiment, the optical disk drive 20 can be easily attached to the electronic equipment 10 manually by the user without recourse to tools. Also, in the detachable structure of the embodiment, the locking pawls 21a are provided at the front of the case 21, and the connector terminal 22 is provided at the back of the case 21. In this manner, the locking pawls 21a acting as the fulcrum of the pivoting and the connector terminal 22 are disposed apart from each other in the front-back direction. As a result, there is a small angle between the connector terminal 13 and the connector terminal 22 upon connection of the connector terminal 22 to the connector terminal 13. The presence of the guide pin 23a allows the connector terminal 22 to be positioned accurately relative to the connector terminal 13. Adopting this structure makes it possible to alleviate loads on the connector terminals 22 and 13 when they come into contact with each other.

Further, in the embodiment, the connector terminal 22 on the side of the optical disk drive 20 protrudes downward, whereas the connector terminal 13 on the side of the electronic equipment 10 is formed in a recessed part of the housing 12. That is, there is no protruding portion related to the connector connection structure on the placement surface 12c of the electronic equipment 10. Thus, in a state where the optical disk drive 20 is not attached, there is no unnecessary protrusion on the electronic equipment 10. This prevents the appearance of the electronic equipment 10 from being deformed by the presence of the connector structure.

### [Shield structure]

FIG. 9 is a top view depicting the circuit board housed in the housing of the electronic equipment as viewed from above. FIG. 10 is a bottom view depicting the circuit board housed in the housing of the electronic equipment as viewed from below.

The electronic equipment 10 has shields that cover the electronic components such as integrated circuits on the circuit board 11 in order to block electromagnetic waves (noise) emanating from the electronic components or block electromagnetic waves coming from the outside. The shields, when provided, prevent the radio waves emitted by an antenna on the circuit board from affecting other electronic components housed in the housing 12 of the electronic equipment 10, or protect the antenna from being affected by radio waves emitted from other electronic components, for example.

The upper shield 111 is provided in a manner covering the upper side of the circuit board 11, as depicted in FIG. 9. A lower shield 112 is provided in a manner covering the underside of the circuit board 11, as indicated in FIG. 10. The upper shield 111 and the lower shield 112 are secured to the circuit board 11 by multiple screws or rivets. The upper shield 111 and the lower shield 112 are each formed of a conductor (metal such as iron, aluminum, or stainless steel).

A ground pattern 11G (see FIG. 9) is formed on the top face of the circuit board 11. In FIG. 9, the hatched regions are where the ground pattern 11G is formed while they are covered by the upper shield 111. The ground pattern 11G is formed along an outer peripheral edge of the circuit board 11, for example. An outer peripheral part 111a of the upper shield 111 is in contact with the ground pattern 11G. Both the outer peripheral part 111a and the ground pattern 11G function as a ground part.

As depicted in FIG. 9, the connector terminal 13 is mounted on the outer peripheral edge of the top face of the circuit board 11. An opening 111b surrounding the connector terminal 13 is formed in the left back portion of the upper shield 111. That is, the upper shield 111 covers the upper side of the circuit board 11 in a manner averting the connector terminal 13. Consequently, the connector terminal 13 is exposed in the left back portion of the upper shield 111.

As depicted in FIG. 6 and elsewhere, a bottom end of the connector housing 23 is provided with a gasket 40, which is a conductive member. The gasket 40 has a ring-like shape surrounding the connector terminal 22 as viewed from below. In a state where the connector terminal 22 and the connector terminal 13 are connected with each other, the gasket 40 may preferably be provided in a manner surrounding at least either the connector terminal 22 or the connector terminal 13.

Further, the gasket 40 is made of a conductive elastic material. The connector housing 23 equipped with the gasket 40 and the lower plate 21U furnished with the connector housing 23 are both made of a conductive material such as metal. Note that the connector housing 23 may preferably be part of the lower plate 21U. That is, the lower plate 21U and the connector housing 23 may preferably be formed integrally.

As depicted in FIG. 8B, in a state where the connector terminal 22 is in the connecting position, the gasket 40 is provided in contact with the ground part of the electronic equipment 10. Further, in the state where the connector terminal 22 is in the connecting position, the gasket 40 is compressed between the ground part of the electronic equipment 10 and the connector housing 23. This causes the connector terminals 13 and 22 to be positioned in a region shielded by the board on which the connectors are mounted, by the connector housing 23, and by the gasket 40.

In the state where the connector terminal 22 is in the connecting position, the gasket 40 electrically connects to the ground pattern 11G and the upper shield 111. This allows the ground part of the electronic equipment 10, and the connector housing 23 and the lower plate 21U of the optical disk drive 20 to be electrically integrated with each other.

Adopting the above-described shield structure prevents electromagnetic waves from emanating via regions where the upper shield 111 is absent, i.e., regions where the opening 111b exposing the connector terminal 13 is formed. Further, this structure also protects the connector terminals 13 and 22 against effects of electromagnetic waves emanating from the electronic components mounted on the circuit board 11.

The embodiment is discussed above using an example where the metal parts electrically connected to the ground part of the electronic equipment 10 via the gasket 40 are the connector housing 23 and the lower plate 21U. However, this is merely one example. Alternatively, a metal part at least as part of the optical disk drive 20 need only connect electrically with the ground part of the electronic equipment 10 via the gasket 40 made of a conductive material.

The embodiment is also discussed above using an example where the gasket 40 is secured to the connector housing 23. Alternatively, the gasket 40 may be secured to the side of the electronic equipment 10.

### [Drive cover 30]

FIG. 11 is a perspective view depicting the drive cover as viewed obliquely from below. FIG. 12 is a left view depicting how the optical disk drive is covered by the drive cover as viewed from left. FIG. 13 is a left view depicting how the optical disk drive is about to be covered by the drive cover as viewed from left. FIG. 14 is a cross-sectional view taken along a section line passing through back locking pawls.

The electronic equipment unit 1 has a drive cover 30 that constitutes part of the exterior of the electronic equipment 10 and covers the optical disk drive 20 attached to the electronic equipment 10. The drive cover 30 is configured to be attachable to and detachable from the electronic equipment 10 manually by the user without recourse to tools.

In a state of being attached to the electronic equipment 10, the drive cover 30 is shaped to have a receiving space R that receives the optical disk drive 20. The drive cover 30 forms the receiving space R with a front part 31, a left part 32, a right part 33, and an upper part 34.

The upper part 34 of the drive cover 30 is shaped to include an inclined surface tilting gently downward toward the back. The left part 32, the right part 33, and the upper part 34 are connected with each other at their bottom ends. The left part 32, the right part 33, and the front part 31 are connected with each other at their bottom ends. The front part 31, the left part 32, the right part 33, and the upper part 34 form a substantially rectangular opening.

Back locking pawls 34a are formed at the back of the upper part 34 of the drive cover 30. There are two back locking pawls 34a formed apart from each other in the right-left direction. Specifically, the two back locking pawls 34a are located in the left back portion and in the right back portion of the drive cover 30. The back locking pawls 34a each include a shape protruding backward, as depicted in an enlarged sectional view in FIG. 14.

Also, as depicted in the enlarged sectional view in FIG. 14, back locking pawls 12d that lock the back locking pawls 34a are formed on the housing 12 of the electronic equipment 10. The back locking pawls 12d each include a shape protruding forward. The back locking pawls 12d may preferably be formed in a manner capable of bending in the front-back direction through elastic deformation.

Front locking pawls 31a are formed on the front part 31 of the drive cover 30. There are two front locking pawls 31a formed part from each other in the right-left direction (second width direction). Further, the locking pawls 31a are disposed on the side opposite to the side where the connector terminal 22 is disposed in the front-back direction (first width direction).

An insertion opening 31b through which the optical disk is to be inserted is formed on the front part 31 of the drive cover 30. In the state where the drive cover 30 is attached to the electronic equipment 10, the insertion opening 31b may preferably be formed in a manner coinciding with the insertion opening 21b of the optical disk drive 20 in the up-down and right-left directions.

As depicted in FIG. 11, a protruding edge 31c is formed along the insertion opening 31b at the front part 31 of the drive cover 30. The protruding edge 31c protrudes backward. That is, the protruding edge 31c protrudes toward the receiving space R.

The front locking pawls 31a each include an extension part 311a extending downward from the protruding edge 31c and a claw part 312a protruding backward from the bottom end of the extension part 311a. The front locking pawls 31a are locked by the housing 12 when inserted into locking holes 12e formed on the front part of the housing 12 of the electronic equipment 10. Note that there may be provided three front locking pawls 31a to be locked by three locking holes 12e indicated in FIG. 4.

When the front locking pawls 31a are to be locked by the housing 12, that portion of the front part 31 of the drive cover 30 which is below the protruding edge 31c may be bent so as to displace the front locking pawls 31a. This configuration allowing the front part 31 to be partially deformed to let the front locking pawls 31a be locked by the housing 12 makes it possible to form the front locking pawls 31a with a shape and a size resisting their deformation. This improves the durability of the front locking pawls 31a. When the extension parts 311a of the front locking pawls 31a are formed integrally with the protruding edge 31c, the strength of the front part 31 of the drive cover 30 is also improved.

In a state of covering the optical disk drive 20, the drive cover 30 may preferably be in partial contact with the top face of the optical disk drive 20. This makes it possible to position the optical disk drive 20 more securely in the up-down direction.

Also, in the state of covering the optical disk drive 20, the drive cover 30 may preferably be in elastic contact therewith. That portion of the drive cover 30 which is in contact with the optical disk drive 20 may preferably be on the side opposite to the side where the locking pawls 21a are provided on the case 21 of the optical disk drive 20 in the direction in which the optical disk is to be inserted.

In the embodiment, as depicted in FIG. 3, an elastic part 24 is provided at the back of the case 21. Further, as indicated in FIG. 11, the drive cover 30 is provided with a protruding part 34b that comes into contact with the elastic part 24 in the state where the drive cover 30 covers the optical disk drive 20.

In this configuration, the front part of the optical disk drive 20 is positioned by the above-mentioned elastic parts 212b in the up-down direction, and the back part of the optical disk drive 20 is positioned by the elastic part 24 in the up-down direction. When positioned by two elastic parts 212b and one elastic part 24, the optical disk drive 20 is stabilized in posture by the three-point support.

Further, as depicted in FIG. 11 and elsewhere, the drive cover 30 may preferably be provided with a positioning part 35. The positioning part 35 is used to position the drive cover 30 with respect to the electronic equipment 10 in the front-back and right-left directions. A positioning hole may preferably be formed on the electronic equipment 10 to let the positioning part 35 be inserted therethrough in the state where the drive cover 30 is attached to the electronic equipment 10.

In the embodiment, the drive cover 30 making up part of the exterior of the electronic equipment 10 covers the optical disk drive 20. As a result, the appearance of the electronic equipment 10 is prevented from being deformed as opposed to the case where an external optical disk drive is connected to the electronic equipment 10 via a cable. Also, the presence of the drive cover 30 better stabilizes the posture of the optical disk drive 20 attached to the electronic equipment 10.

### [Others]

That part of the connector terminal 22 which comes into contact with the connector terminal 13 may preferably be in a floating structure. Specifically, that part of the connector terminal 22 in contact with the connector terminal 13 may preferably be displaceable elastically in the front-back direction. In the case where the connector terminal 22 in an inclined state is connected to the connector terminal 13, this structure allows the connection to be made without overloading the connector terminal 22. Alternatively, the connector terminal 13 instead of the connector terminal 22 may be in a floating structure.

The embodiment is discussed above using an example where there are two locking pawls 21a formed on the case 21. Alternatively, there may be provided one locking pawl 21a or three or more locking pawls 21a. In the case where there is provided one locking pawl 21a, the locking pawl 21a may preferably be formed at the center of the case 21 in the right-left direction. Likewise, there may be one front locking pawl 31a and one back locking pawl 34a, or three or more front locking pawls 31a and three or more back locking pawls 34a formed on the drive cover 30.

The embodiment is also discussed above using an example where the locking pawls 21a are formed on the case 21. Alternatively, instead of the locking pawls 21a, there may be provided supported parts at one end of the case 21 which are supported by the electronic equipment 10. The supported parts may be supported by the electronic equipment 10 in a manner allowing the connector terminal 22 to pivot between the connecting position and the non-connecting position.

### [Conclusion]

For example, the connection structure and the optical disk drive may be configured as follows.
(1) A connection structure allowing electronic equipment and an optical disk drive detachably attachable thereto to be electrically connected with each other, the connection structure including a first connector terminal provided on the optical disk drive, a second connector terminal provided on the electronic equipment in a manner connectable to the first connector terminal, a circuit board housed in a housing of the electronic equipment, the circuit board having the second connector terminal mounted thereon, a ground part provided on the circuit board, and a conductive member causing the ground part and a metal part of the optical disk drive to be electrically connected with each other in a state where the first connector terminal and the second connector terminal are connected with each other.
(2) The connection structure according to (1), in which the ground part includes a ground pattern and a shield, the ground pattern being formed on the circuit board, the shield covering electronic components mounted on the circuit board.
(3) The connection structure according to (2), in which the shield is provided on the circuit board in a manner exposing the second connector.
(4) The connection structure according to any one of (1) to (3), in which the conductive member has a ring-like shape surrounding at least either one of the first connector terminal or the second connector terminal in the state where the first connector terminal and the second connector terminal are connected with each other.
(5) The connection structure according to any one of (1) to (4), in which the conductive member is made of an elastic material in elastic contact with the shield in the state where the first connector terminal and the second connector terminal are connected with each other.
(6) The connection structure according to any one of (1) to (5), in which the conductive member is secured to the optical disk drive.
(7) The connection structure according to any one of (1) to (6), in which the metal part includes a conductive connector housing that houses the first connector terminal, and the conductive member is secured to the connector housing.
(8) The connection structure according to (7), in which the connector housing is provided with a guide pin that guides the first connector terminal being moved when the first connector terminal is connected to the second connector terminal, and a guide hole through which the guide pin is inserted is formed on the circuit board.
(9) The connection structure according to any one of (1) to (8), in which the metal part includes a lower plate of the optical disk drive for placement onto the electronic equipment.
(10) The connection structure according to (9), in which a connector housing that houses the first connector terminal is formed on the lower plate.
(11) An optical disk drive detachably attachable to electronic equipment, the optical disk drive including a connector terminal connectable to an equipment-side connector terminal mounted on a circuit board of the electronic equipment, and a conductive member electrically connected to a ground part provided on the circuit board in a state where the connector terminal is connected to the equipment-side connector terminal.

## Claims

1. A connection structure allowing electronic equipment and an optical disk drive detachably attachable thereto to be electrically connected with each other, the connection structure comprising:
a first connector terminal provided on the optical disk drive;
a second connector terminal provided on the electronic equipment in a manner connectable to the first connector terminal;
a circuit board housed in a housing of the electronic equipment, the circuit board having the second connector terminal mounted thereon;
a ground part provided on the circuit board; and
a conductive member causing the ground part and a metal part of the optical disk drive to be electrically connected with each other in a state where the first connector terminal and the second connector terminal are connected with each other.

2. The connection structure according to claim 1, wherein the ground part includes a ground pattern and a shield, the ground pattern being formed on the circuit board, the shield covering electronic components mounted on the circuit board.

3. The connection structure according to claim 2, wherein the shield is provided on the circuit board in a manner exposing the second connector.

4. The connection structure according to claim 3, wherein the conductive member has a ring-like shape surrounding at least either one of the first connector terminal or the second connector terminal in the state where the first connector terminal and the second connector terminal are connected with each other.

5. The connection structure according to claim 1, wherein the conductive member is made of an elastic material in elastic contact with the shield in the state where the first connector terminal and the second connector terminal are connected with each other.

6. The connection structure according to claim 1, wherein the conductive member is secured to the optical disk drive.

7. The connection structure according to claim 1, wherein
the metal part includes a conductive connector housing that houses the first connector terminal, and
the conductive member is secured to the connector housing.

8. The connection structure according to claim 7, wherein
the connector housing is provided with a guide pin that guides the first connector terminal being moved when the first connector terminal is connected to the second connector terminal, and
a guide hole through which the guide pin is inserted is formed on the circuit board.

9. The connection structure according to claim 1, wherein the metal part includes a lower plate of the optical disk drive for placement onto the electronic equipment.

10. The connection structure according to claim 9, wherein a connector housing that houses the first connector terminal is formed on the lower plate.

11. An optical disk drive detachably attachable to electronic equipment, the optical disk drive comprising:
a connector terminal connectable to an equipment-side connector terminal mounted on a circuit board of the electronic equipment; and
a conductive member electrically connected to a ground part provided on the circuit board in a state where the connector terminal is connected to the equipment-side connector terminal.
